# EUROPEAN PATENT APPLICATION

(11) **EP 4 847 663 A1**
(43) Date of publication of application: **02.12.2026**
(21) Application number: 25211246.1
(22) Date of filing: 27.10.2025
(51) Int. Cl.: C23C 16/455, B05B 5/025, B82B 3/00, B82Y 40/00, H10P 72/00, H10D 62/10

(54) **NANOFLUID DISPENSER AND APPARATUS FOR MANUFACTURING SEMICONDUCTOR DEVICES INCLUDING THE SAME**

(30) Priority: 26.05.2025 KR 20250068290
(71) Applicant: University Of Ulsan Foundation For Industry Cooperation, Ulsan 44610 (KR)
(72) Inventor: KIM, Bo Hung, 44610 Ulsan (KR); HOSSAIN, Jaber Al, 44610 Ulsan (KR); KARIM, Kazi Ehsanul, 44610 Ulsan (KR); O, Chaerin, 44610 Ulsan (KR)
(74) Representative: Zacco Sweden AB

(57) **Abstract**

Disclosed are a nanofluid dispenser and a semiconductor manufacturing apparatus and manufacturing method including the same. The nanofluid dispenser includes a supply member transporting a process fluid and providing a reservoir in which the process fluid is contained; a shower head of hydrophobic insulating material coupled to an end of the supply member to define the reservoir and including a plurality of nanochannels to allow the process fluid to flow from the reservoir with nanoscale dimensions, to thereby discharge the process fluid as a nanofluid; and a nanofluid driving unit applying a driving force to cause the nanofluid to flow along the nanochannels. A nanostructure having a nanoscale line width smaller than an exposure resolution and a high-capacity semiconductor device including the same may be easily manufactured.

## Description

### BACKGROUND

### 1. Field

This research was supported by the National Research Foundation of Korea (NRF) grant funded by the Korean government (Ministry of Science and ICT) (No. RS-2023-00272214).

The present disclosure relates to a nanofluid dispenser and a semiconductor device manufacturing apparatus including the same, and more particularly, to a nanofluid dispenser for a microprocess of a semiconductor device and a semiconductor device manufacturing apparatus including the same.

### 2. Description of the Related Art

As a demand for a high-integrated low-power semiconductor device increases, technology development for a fine process capable of reducing the line width of the semiconductor device in units of nanometers is being actively developed.

When the circuit line width of the semiconductor device is reduced in units of nanometers, various efforts have been made to develop a fine process according to an increase in demand for high-performance low-power semiconductor devices, such as an artificial intelligence chip, since more transistors may be integrated in the same area to improve calculation performance and power efficiency.

A general semiconductor device manufacturing process may be divided into a film-forming process forming a thin film on a substrate and a patterning process of selectively removing a thin film and forming a designed circuit pattern.

After forming a thin film to have a thickness set on the substrate, a circuit pattern may be formed on the substrate by setting a removal region of the thin film by exposure to the substrate and removing the thin film through etching. Then, vias or connectors for interconnecting circuit patterns stacked on insulating layers are formed through thin film and patterning processes, thereby fabricating a semiconductor front-end device prior to packaging.

However, when the patterning process is performed using a nano process that reduces the linewidth of the patterns to the nanometer scale, it is required that the wavelength of the exposure light be shorter than that of extreme ultraviolet (EUV) light for distinguishing adjacent patterns, which implies significant technical challenges in implementing nanometer-scale linewidths through the exposure process.

In particular, the film-forming process is performed by depositing or coating the film material, and the patterning process is carried out by the suppling etching materials to the mask layer or thin film, so that various efforts have been made to supply the raw materials required for these processes at the nanoscale.

However, when the film-forming or patterning processes are performed at the nanoscale by supplying raw materials through nanochannels, which are conduits with nanoscale dimensions, there are some problems in maintaining uniform flow of the raw materials due to the characteristics of nanoparticles, such as intermolecular interactions and reduced viscosity. Hereinafter, a fluid that exhibits the characteristics of nanoparticles and flows through nanochannels is referred to as a nanofluid.

Accordingly, there is an increasing need for a nanofluid dispenser capable of uniformly supplying nanofluids through a corresponding manufacturing process by overcoming the high slip characteristics of nanochannels and the entrance pressure barrier and a semiconductor manufacturing apparatus including with the same

Relevant background art includes patent documents, such as US20230047588A1, US8940173B2, US10386718B2, US9733576B2, US8428762B2, US7718551B2, US20070128355A1, EP2376215B1, US20170368508A1, and CN115711842A, as well as non-patent literature including Langmuir 2021, 37, 6498-6509 and Phys. Chem. Chem. Phys., 2023, 25, 24919.

### SUMMARY

The present invention is proposed to solve the aforementioned problems, and an object of the present invention is to provide a nanofluid dispenser for semiconductor fine processes configured to supply nanofluids accurately and uniformly to designated locations by controlling the flow characteristics of the nanofluids.

Another object of the present invention is to provide an apparatus for manufacturing semiconductor devices including the nanofluid dispenser described above.

Still another object of the present invention is to provide a method of manufacturing semiconductor devices the nanofluid dispenser described above in fine processes.

The technical problems of the present invention are not limited to the aforementioned objects, and other objects and advantages of the present invention that are not explicitly mentioned are evidently understood from the following description and will become more apparent from the embodiments of the present invention. It will also be readily understood that the objects and advantages of the present invention are capable of being realized by the means and their combinations set forth in the claims of the invention.

The present invention is adapted to be applied to a semiconductor manufacturing process using a fluid.

According to an aspect of the inventive concept, there is provided a nanofluid dispenser including a supply member configured to transport a process fluid to a semiconductor fine process for manufacturing semiconductor devices with nanoscale dimensions and to provide a reservoir in which the process fluid is contained, a shower head coupled to an end of the supply member to define the reservoir and including a plurality of nanochannels configured to allow the process fluid to flow from the reservoir with nanoscale dimensions, thereby discharging the process fluid as a nanofluid, and a nanofluid driving unit configured to apply a driving force to cause the nanofluid to flow along the nanochannels.

In an exemplary embodiment, the nanofluid dispenser may further include a pressurizing unit configured to apply pressure to the process fluid contained in the reservoir. In an exemplary embodiment, the pressurizing unit may include a pressurizing pump configured to supply the process fluid into the reservoir.

In an exemplary embodiment, the supply member may include a reservoir cover connected to the shower head to define the reservoir together with the shower head, and a transfer tube connected to the reservoir cover to supply the process fluid into the reservoir. In an exemplary embodiment, the pressurizing pump may supply the process fluid into the reservoir through a supply pipe.

In an exemplary embodiment, a flow cross-sectional area of the transfer tube may be smaller than an area of the shower head facing the reservoir.

In an exemplary embodiment, the shower head may include at least one of a plurality of nanochannels and nanoporous membrane.

In an exemplary embodiment, the shower head may include a plurality of nanochannels extending outward from the reservoir and arranged adjacent to each other in a lateral direction. In an exemplary embodiment, the plurality of nanochannels may be provided as a nano passage.

In an exemplary embodiment, the plurality of nanochannels may be configured as a plurality of single-walled carbon nanotubes.

In an exemplary embodiment, the shower head may include nanoporous membrane. In an exemplary embodiment, the nanoporous membrane may provide a plurality of nano passages.

In an exemplary embodiment, the nanoporous membrane may include a graphene membrane or a graphene sheet.

In an exemplary embodiment, the process fluid may be a liquid containing ions.

In an exemplary embodiment, each diameter of the nanochannels may be determined within a range in which the process fluid cannot pass through the nanochannels in the absence of an electric field but may pass through the nanochannels by electroosmosis when an electric field is applied.

In an exemplary embodiment, the pressure of the process fluid contained in the reservoir may be determined within a range in which the fluid cannot pass through the nanochannels when no electric field is applied but may pass through the nanochannels by electroosmosis when an electric field is applied.

In an exemplary embodiment, the shower head may be connected to the supply member so as to be electrically insulated from each other.

In an exemplary embodiment, the power unit may include a first power supply configured to generate a first electric field around the nanochannels and a second power supply configured to generate a second electric field between the supply member and the stage.

In an exemplary embodiment, the first electric field and the second electric field may be generated independently from each other.

In an exemplary embodiment, the first electric field may cause ions of the process fluid to accumulate near the side surface of the nanochannels, thereby forming an electric double layer in the nanochannels. In an exemplary embodiment, the second electric field may cause ions in the electric double layer to move under influence thereof, thereby allowing the process fluid to move along the nanochannels.

In an exemplary embodiment, the nanofluid dispenser may further include a flow controller configured to control operation of the power unit.

In an exemplary embodiment, each diameter of the nanochannels, calculated as a diameter of a virtual circle having an area equivalent to a flow cross-section of the nanochannel, may be in a range of 0.5 nm to 20 nm.

In an exemplary embodiment, the plurality of nanochannels may be substantially uniformly distributed on an inner surface of the shower head that defines the reservoir.

In an exemplary embodiment, a predetermined pattern shape may be provided on the inner surface of the shower head.

In an exemplary embodiment, a plurality of nanochannels may penetrate the shower head from the inner surface to the outer surface.

In an exemplary embodiment, the plurality of nanochannels may be substantially uniformly distributed in the shower head.

In an exemplary embodiment, the nanofluid dispenser may further include an auxiliary head arranged on at least one of an inner surface of the shower head defining the reservoir and an outer surface spaced from the inner surface by a thickness of the shower head.

In an exemplary embodiment, the auxiliary head may include an injection head having a plurality of penetrating holes distributed in a predetermined pattern shape along the flow direction of the process fluid, to define an exposure pattern.

In an exemplary embodiment, the plurality of nanochannels may be substantially uniformly distributed in a region where the shower head and the injection pattern are in contact.

In an exemplary embodiment, the auxiliary head may include a reinforcing head for reducing deformation of the shower head caused by pressure difference between the inner surface and the outer surface of the shower head.

In an exemplary embodiment, the flow controller may control the first electric field and the second electric field, respectively, to control the flow velocity and flow rate of the nanofluid.

According to another aspect of the inventive concept, there is provided an apparatus for manufacturing semiconductor devices.

In an exemplary embodiment, the apparatus may include a stage on which a semiconductor substrate having a processing object thereon is disposed and the nanofluid dispenser for dispensing the nanofluid onto the processing object.

In an exemplary embodiment, the process fluid contained in the reservoir may be discharged onto the processing object through the plurality of nanochannels that is arranged in the shower head.

In an exemplary embodiment, the plurality of nanochannels may be distributed in a predetermined pattern shape.

In an exemplary embodiment, the nanofluid dispenser may further include an auxiliary head arranged on at least one of an inner surface of the shower head defining the reservoir and an outer surface spaced from the inner surface by a thickness of the shower head.

In an exemplary embodiment, the process fluid in the reservoir may be supplied to the substrate through a plurality of nanochannels arranged in a region of the shower head facing the substrate.

In an exemplary embodiment, the auxiliary head may include an injection head having a plate shape that entirely covers the shower head, and perforated in a predetermined pattern to provide an exposure pattern that selectively exposes the shower head, and the process fluid contained in the reservoir may be discharged onto the substrate through the nanochannels communicating with the exposure pattern.

In an exemplary embodiment, the nanofluid may be deposited on the substrate or the processing object at the nanoscale to form a nano-deposition pattern.

In an exemplary embodiment, the nanofluid may etch a thin film on the substrate at the nanoscale to form a nano-etching pattern.

In an exemplary embodiment, the processing object may include a photoresist layer.

In an exemplary embodiment, the nanofluid may include an etching solution.

In an exemplary embodiment, the power unit may include a first power supply configured to generate a first electric field around the nanochannels and a second power supply configured to generate a second electric field between the supply member and the stage.

In an exemplary embodiment, each of the plurality of nanochannels may have a circular flow cross-section parallel to a surface of the shower head, and the circular flow cross-section may have a diameter in a range of 0.5 nm to 20 nm.

In an exemplary embodiment, the plurality of nanochannels may be substantially uniformly distributed on a front surface of the shower head having a flat plate shape.

In an exemplary embodiment, the plurality of nanochannels may be arranged such that a cross-sectional shape taken along a front surface of the shower head is configured as a predetermined pattern shape, thereby allowing the nanofluid to be discharged along the pattern shape.

In an exemplary embodiment, the supply member may include a transfer tube transporting the process fluid to the reservoir from a fluid source and an open-type reservoir cover having a diameter greater than that of the transfer tube and connected to an end of the transfer tube 110 and to the shower head, thereby defining the reservoir.

In an exemplary embodiment, the supply member may further include a pressurizing unit connected to the transfer tube so as to pressurize the process fluid to the shower head.

In an exemplary embodiment, the nanofluid dispenser may further include an auxiliary head arranged on at least one of an inner surface of the shower head defining the reservoir and an outer surface spaced from the inner surface by a thickness of the shower head.

In an exemplary embodiment, the auxiliary head may include an injection head having a plate shape that entirely covers the shower head, and perforated in a predetermined pattern to provide an exposure pattern that selectively exposes the shower head, thereby selectively limiting one of a flow area of the process fluid and a discharge area of the nanofluid.

In an exemplary embodiment, the auxiliary head may include a reinforcing head arranged to cover at least a portion of the shower head to reduce deformation of the shower head caused by pressure difference between the inner surface and the outer surface of the shower head.

In an exemplary embodiment, the reinforcing head may include a reinforcing frame in which a plurality of transverse rods, arranged at regular intervals along a transverse direction, and a plurality of longitudinal rods, arranged at regular intervals along a longitudinal direction perpendicular to the transverse direction in a shape corresponding to the shower head, may be connected to intersect with each other and coupled to the shower head.

In an exemplary embodiment, the nanofluid dispenser may further include an auxiliary head arranged on at least one of an inner surface of the shower head defining the reservoir and an outer surface spaced from the inner surface by a thickness of the shower head.

In an exemplary embodiment, the auxiliary head may include an injection head having a plate shape that entirely covers the shower head, and perforated in a predetermined pattern to provide an exposure pattern that selectively exposes the shower head, thereby selectively limiting a discharge area of the nanofluid.

In an exemplary embodiment, the auxiliary head may include a reinforcing head arranged to cover at least a portion of the shower head to reduce deformation of the shower head caused by pressure difference between the inner surface and the outer surface of the shower head.

In an exemplary embodiment, the etching mask may include a photoresist layer.

According to another aspect of the inventive concept, there is provided a method of manufacturing semiconductor devices.

In an exemplary embodiment, the method may include a step of coupling a shower head having a plurality of nanochannels to an end of a supply member and having a reservoir, such that the reservoir is defined and communicates with the outside through the nanochannels, a step of loading a semiconductor substrate having a processing object thereon onto a stage opposite to the shower head, a step of supplying a process fluid for processing the processing object into the reservoir via the supply member, and a step of discharging the process fluid contained in the reservoir onto the processing object through the nanochannels as a nanofluid with nanoscale precision, thereby forming the processing object into a nanostructure.

In an exemplary embodiment, the step of supplying the process fluid into the reservoir may be performed by a pressurizing pump, a reservoir pressure applied to the process fluid in the reservoir being higher than a process pressure applied around the processing object, so that a pressure gradient toward the processing object is formed from the reservoir.

In an exemplary embodiment, the step of discharging the process fluid may include a step of generating a circular first electric field surrounding the nanochannels to form the nanofluid into an electric double layer within the nanochannels and a step of generating a linear second electric field along the nanochannels to move the electric double layer along the nanochannels.

In an exemplary embodiment, the first electric field may be generated by a first power supply connected to the shower head, and the second electric field may be generated by a second power supply connected to the supply member and the stage.

In an exemplary embodiment, the nanochannels may be uniformly distributed on the shower head, so that the nanofluid is uniformly discharged from the shower head.

In an exemplary embodiment, the nanofluid may be non-uniformly discharged along a pattern shape defined by an arrangement of the nanochannels of the shower head.

In an exemplary embodiment, prior to the step of coupling the shower head to the supply member, the method may further include a step of coupling an injection head having an exposure pattern to the shower head, to entirely cover the shower head.

In an exemplary embodiment, the nanofluid may include any one of an etching fluid, a cleaning fluid, a deposition fluid.

In an exemplary embodiment, each of the plurality of nanochannels may be formed to a carbon nanotube with a nanoscale diameter.

In an exemplary embodiment, the shower head may be formed into a nanoporous membrane having a plurality of nanopores individually corresponding to the plurality of nanochannels.

In an exemplary embodiment, the processing object may include a thin film disposed on the semiconductor substrate and an etching mask layer for etching the thin film, and the nanofluid includes an etching solution for etching the mask layer, such that the nanofluid is adapted to be discharged onto the mask layer along a pattern shape that is an arrangement form of the nanochannels of the shower head, thereby etching the mask layer into an etching mask pattern along which the thin film is etched.

In an exemplary embodiment, the processing object may include a thin film disposed on the semiconductor substrate and a nanopattern disposed on the thin film and partially exposing the thin film with nanoscale precision, and the nanofluid includes a cleaning solution for cleaning the nanopattern, such that the nanofluid is adapted to be discharged to the nanopattern along a pattern shape that is an arrangement form of the nanochannels of the shower head corresponding to the nanopattern, thereby cleaning the nanopattern.

In an exemplary embodiment, the processing object may include a nano template having a plurality of nanopores, and the nanofluid includes a carbon deposition fluid, such that the nanofluid is adapted to be discharged to the plurality of nanopores along a pattern shape that is an arrangement form of the nanochannels of the shower head corresponding one-to-one with the nanopores, thereby forming a plurality of carbon nanotubes that respectively fill the plurality of nanopores.

According to an embodiment of the present invention as described above, a plurality of nanochannels may be arranged in a predetermined pattern shape in the shower head, and the process fluid may flow through the nanochannels by electroosmosis to generate a nanofluid with nanoscale dimensions, which is supplied to a processing object for manufacturing a semiconductor device. Then, the processing object is formed into a nano structure by a fine process.

The shower head may be configured as a hydrophobic plate including carbon nanochannels or as a nanoporous membrane with nanopores, thereby providing nanochannels with nanoscale dimensions.

The injection head having an exposure pattern may be coupled to the shower head to supply the nanofluid along the shape of the exposure pattern. In addition, the nanofluid may be discharged onto the processing object along the pattern shape corresponding to the arrangement form of the nanochannels in the shower head, partially removing the processing object disposed on the substrate to form a nano-etching pattern with a nanoscale line width. Furthermore, the nanofluid may be individually deposited into each nanopore of a template disposed on the substrate to form a nano-deposition pattern on the substrate.

Accordingly, the nanopattern having a line width smaller than the resolution of the exposure process may be easily formed, enabling the manufacture of high-performance, low-power semiconductor devices.

In particular, the nanofluid may be various types of fluids depending on the characteristics of the fine process. Thus, fine processes using the nanofluid may be performed in various unit processes of the semiconductor manufacturing process, such as film formation, patterning, and cleaning processes.

In addition to the effects described above, the specific effects of the present invention will be described while explaining the detailed embodiments for carrying out the invention.

### BRIEF DESCRIPTION OF THE DRAWINGS

Embodiments will be more clearly understood from the following detailed description taken in conjunction with the accompanying drawings in which:
FIG. 1 is a schematic diagram illustrating a nanofluid dispenser according to an embodiment of the present disclosure;
FIG. 2 is an exploded perspective view of the nanofluid dispenser shown in FIG. 1;
FIG. 3 is a cross-sectional view illustrating the shower head shown in FIG. 2, according to an embodiment of the present disclosure;
FIG. 4 is a perspective view illustrating the carbon nanochannel arranged in the shower head shown in FIG. 3;
FIG. 5 is a cross-sectional view illustrating another embodiment of the nanochannels shown in FIG. 3;
FIG. 6 is a perspective view illustrating a shower head according to another embodiment of the present disclosure;
FIG. 7 is a plan view illustrating a shower head according to still another embodiment of the present disclosure;
FIG. 8 is a view illustrating an electric double layer formed in a nanochannel according to an embodiment of the present disclosure;
FIG. 9 is a view illustrating the state in which a nanofluid flows as an electric field is applied to the electric double layer shown in FIG. 8;
FIG. 10 is a plan view illustrating the auxiliary head according to another embodiment of the present disclosure;
FIG. 11 is a schematic diagram illustrating a semiconductor device manufacturing apparatus equipped with the nanofluid dispenser shown in FIG. 1;
FIG. 12 is an exploded perspective view illustrating the semiconductor device manufacturing apparatus shown in FIG. 11;
FIGS. 13 to 15 are cross-sectional views illustrating steps of performing a nano-etching process on a processing object disposed on a semiconductor substrate, according to an embodiment of the present disclosure;
FIGS. 16 to 19 are cross-sectional views illustrating steps of performing a nano-deposition process on a processing object disposed on a semiconductor substrate, according to an embodiment of the present disclosure; and
FIG. 20 is a flowchart illustrating a method of manufacturing a semiconductor device using the semiconductor device manufacturing apparatus disclosed in FIGS. 11 and 12.

### DETAILED DESCRIPTION OF THE EMBODIMENTS

Hereinafter, preferred embodiments of the present invention will be described in detail with reference to the accompanying drawings.

The present invention is not limited to an embodiment disclosed below and may be modified in various ways and implemented in various different forms. The present embodiment is provided merely to make the disclosure of the present invention complete and to fully inform those skilled in the art of the scope of the invention. Accordingly, the present invention is not limited to the embodiments disclosed below, and it should be understood to include all modifications, equivalents, and alternatives within the technical scope of the invention, including substituting or adding the components of one embodiment with those of another embodiment.

The accompanying drawings are provided merely to facilitate an understanding of the embodiments disclosed in this specification, and the technical idea disclosed in this specification is not limited by the accompanying drawings. It should be understood to include all modifications, equivalents, and alternatives within the spirit and scope of the present invention. Although the components shown in the drawings may be exaggeratedly enlarged or reduced in size or thickness for the sake of clarity or convenience of understanding, this should not be construed as limiting the scope of protection of the present invention.

The terminology used in this specification is employed merely to describe particular embodiments or examples and is not intended to limit the present invention. Furthermore, the singular expressions include the plural expressions unless the context clearly indicates otherwise. In this specification, terms such as 'include' or 'comprise' are intended to indicate the presence of the features, numbers, steps, operations, components, parts, or combinations thereof described in the specification. That is, terms such as 'include' or 'comprise' in the specification should be understood as not precluding the presence or addition of one or more other features, numbers, steps, operations, components, parts, or combinations thereof.

Terms including ordinals such as 'first' and 'second' may be used to describe various components, but the components are not limited by these terms. These terms are used solely for the purpose of distinguishing one component from another. Accordingly, unless explicitly stated otherwise, the first component may also be the second component.

When a component is described as being 'connected to' or 'coupled to' another component, it should be understood that the component may be directly connected or coupled to the other component, or that one or more other components may exist in between. On the other hand, when a component is described as being 'directly connected to' or 'directly coupled to' another component, it should be understood that no other components exist in between.

When a component is described as being 'above' or 'below' another component, it should be understood that the component may not only be disposed immediately above or below the other component, but that one or more other components may exist in between.

Unless otherwise defined, all terms used herein, including technical and scientific terms, have the same meanings as those generally understood by one of ordinary skill in the art to which the present invention belongs. Terms that are generally defined in dictionaries should be interpreted as having meanings consistent with their meanings in the context of the relevant art, and unless explicitly defined in the present application, they are not to be interpreted in an idealized or overly formal sense.

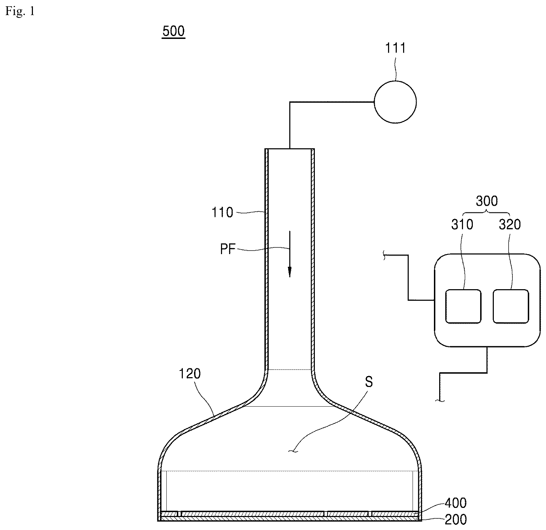

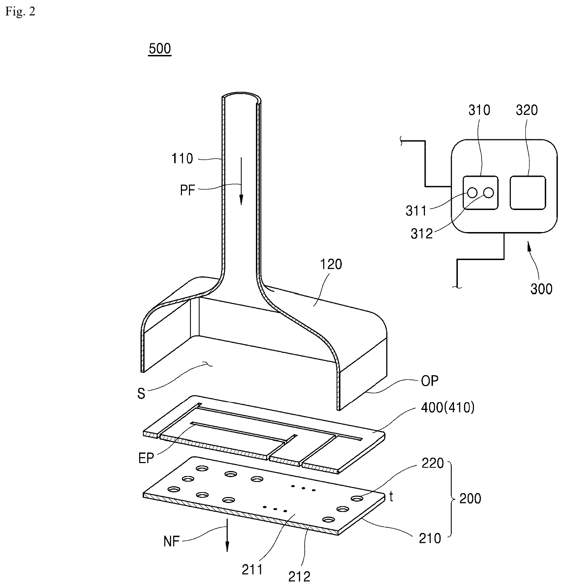

FIG. 1 is a schematic diagram illustrating a nanofluid dispenser according to an embodiment of the present disclosure, and FIG. 2 is an exploded perspective view of the nanofluid dispenser shown in FIG. 1.

Referring to FIGS. 1 and 2, a nanofluid dispenser 500 according to an embodiment of the present disclosure may include a supply member 100 having a reservoir S and supplying a process fluid PF for fine processes, a shower head 200 provided with a plurality of nanochannels 220 and configured to convert the process fluid into a nanofluid, a nanofluid driving unit 300 that provides driving force to cause the nanofluid to flow through the nanochannels 220, and an injection head disposed in the shower head 200.

The nanofluid dispenser 500 may be variously arranged and used in different unit processes of a semiconductor device manufacturing apparatus when a nanofluid having a nanoscale size needs to be supplied. The nanofluid dispenser 500 enables process fluids required for the unit processes to be supplied at the nanoscale, thereby allowing fine processes to be performed.

In an embodiment, the supply member 100 may transport the process fluid PF to a semiconductor fine process, which is a manufacturing process for producing semiconductor devices with nanoscale dimensions. In particular, one end of the supply member 100 is provided with a reservoir S configured to temporarily store the process fluid PF, so that the process fluid PF transferred from a fluid source (not shown) may be discharged into the fine process through the shower head 200.

For example, the supply member 100 may include a transfer tube 110 for transporting the process fluid PF and an open-type reservoir cover 120 connected to the transfer tube 110 to define the reservoir S.

The transfer tube 110 may be connected to the fluid source in which the process fluid PF is stored and extend to a process chamber in which the fine process is performed. The transfer tube 110 may be configured to have appropriate resistance according to the characteristics of the process fluid PF required for the fine process.

In particular, the transfer tube 110 may be provided with a pressurizing unit 111, which is able to reliably transport the process fluid PF from the fluid source to the process chamber. In addition, depending on the transfer pressure of the pressurizing unit 111, the internal pressure of the reservoir S provided at the end of the transfer tube 110 may be configured to set higher than the internal pressure of the process chamber.

Accordingly, the process fluid PF may be subjected to a pressure acting toward the shower head 200 in the reservoir S. In particular, when the internal pressure of the process chamber is maintained at a vacuum, the process fluid PF may be forced to flow toward the shower head 200 due to the internal pressure of the reservoir S.

The pressurizing unit 111 may be configured as a pressurizing structure, such as an appropriate vacuum pump, according to the characteristics of the fine process.

The reservoir cover 120 may have a larger diameter than the transfer tube 110 and be configured as an open cover connected to one end of the transfer tube 110, thereby defining the reservoir S. The flow space of the process fluid PF may expand in the reservoir S compared to the transfer tube 110, resulting in a significantly reduced fluid velocity in the reservoir S relative to the transfer tube 110. Accordingly, the process fluid PF transported through the transfer tube 110 may be contained in the reservoir S and be discharged through the shower head 200 coupled below.

The reservoir cover 120 may be configured as a concave plate with one end open and may include an opening, which is connected to the transfer tube 110, at the center. For example, the reservoir cover 120 may be configured with a concave shape that curves away from the transfer tube 110, so that an opening end OP of the reservoir cover 120 may be positioned opposite to an end portion of the transfer tube 110.

For example, the process fluid PF may be a fluid including ions. For example, the process fluid PF may include an aqueous solution in which polar molecules are dissolved, a solution in which polar molecules are dissolved in a polar solvent, or a gas containing charged particles such as ions or radicals.

In an embodiment, the shower head 200 may be coupled to the opening end OP of the reservoir cover 120 to define the reservoir S. Accordingly, the shower head 200 may have a shape corresponding to the opening end OP of the reservoir S and may be provided as a plate having a relatively large thickness or as a sheet having a relatively small thickness.

For example, the shower head 200 may include a head body 210 made of a hydrophobic insulating material, which is electrically insulated from the supply member 100 and coupled to separate the reservoir S from the outside, and may be provided with nanochannels 220, which are nanoscale openings passing through the head body 210, so that the process fluid PF contained in the reservoir S is able to be discharged to the outside of the reservoir S.

In this embodiment, the head body 210 may be made of a non-polar polymer having no electrical polarity and be configured as a plate having the same shape as the opening end OP and a predetermined thickness, and the nanochannels 220 may be configured as separate carbon nanotubes T passing through the head body 210.

Accordingly, the head body 210 may be disposed toward the reservoir S and provided as a plate having an inner surface 211 defining the reservoir S and an outer surface 212 spaced from the inner surface 211 by the thickness t of the head body 210 and positioned symmetrically with respect to the inner surface 211, and a plurality of carbon nanotubes T may be arranged in the same plane as the inner surface 211 and the outer surface 212 or may be arranged to pass through at least one of them.

In particular, the head body 210 may be made of a hydrophobic or nonpolar material to reduce the wettability with respect to the process fluid PF supplied in the form of an aqueous solution or a polar substance, thereby reducing the flow resistance of the fluid. Accordingly, the flow uniformity of the process fluid PF introduced into the nanochannels 220 may be improved.

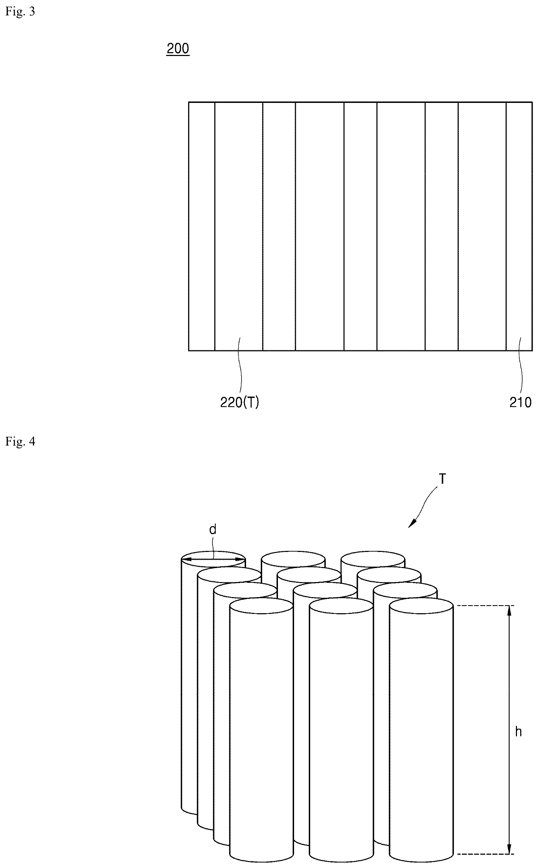

FIG. 3 is a cross-sectional view illustrating the shower head shown in FIG. 2, according to an embodiment of the present disclosure, and FIG. 4 is a perspective view illustrating the carbon nanochannel arranged in the shower head shown in FIG. 3.

Referring to FIGS. 3 and 4, a plurality of carbon nanotubes T having a nanoscale diameter d and a height h that is greater than or equal to the thickness of the head body 210 may be uniformly arranged to penetrate the head body 210, thereby forming the nanochannels 220.

That is, the plurality of carbon nanotubes T may be uniformly arranged over the entire surface of the head body 210 such that one end and the other end thereof are substantially flush with the inner surface 211 and the outer surface 212, respectively.

Accordingly, the process fluid PF may be uniformly introduced into the nanochannels 220 through the entire inner surface 211, and a nanofluid NF may be uniformly discharged through the entire outer surface 212.

The carbon nanotube T may have a long, hollow hexagonal tubular structure with a wall formed of a single layer of graphene, which is a carbon allotrope, and may exhibit either conductive or semiconductive properties depending on shape and diameter thereof.

In this embodiment, the carbon nanotube T may be configured as a single-walled carbon nanochannel in which graphene grows in a helical form, or as a multi-walled carbon nanochannel in which graphite grows in a helical form, depending on the characteristics of the fine process.

The carbon nanotube T having a hexagonal tubular structure may have a diameter d in the range of approximately 0.3 nm to 40 nm, preferably in the range of approximately 0.5 nm to 20 nm. Accordingly, the nanochannels 220 of the shower head 200 may discharge the process fluid PF at a nanoscale corresponding to the tube diameter d of the carbon nanotubes T.

When passing through nanoscale penetrating holes directly provided in the head body 210, the process fluid PF may be subjected to a high entrance pressure at the inlet of the penetrating holes, and the high wettability of the inner surfaces of the penetrating holes makes it difficult to ensure uniform flow. Poor flow uniformity of the nanofluid results in reduced uniformity of the fine process, thereby increasing the likelihood of defects in the process.

The carbon nanotubes T may have hydrophobic properties and sufficient slip conditions to reduce wettability, thereby lowering the entrance pressure of the process fluid entering the inside of the hexagonal carbon nanotubes T and significantly improving the uniformity of internal flow of the carbon nanotubes T. Accordingly, when the nanochannels 220 of the shower head 200 are provided as the carbon nanotubes T, the uniformity of the nanofluid NF discharged from the shower head 200 may be improved, thereby sufficiently enhancing the process uniformity of the fine process.

In this embodiment, the nanochannels 220 may be configured as a tube group including at least one carbon nanotube T having the shape characteristics described above. That is, in this embodiment, a single nanochannel 220 may be configured as a bundle of at least one carbon nanotube T.

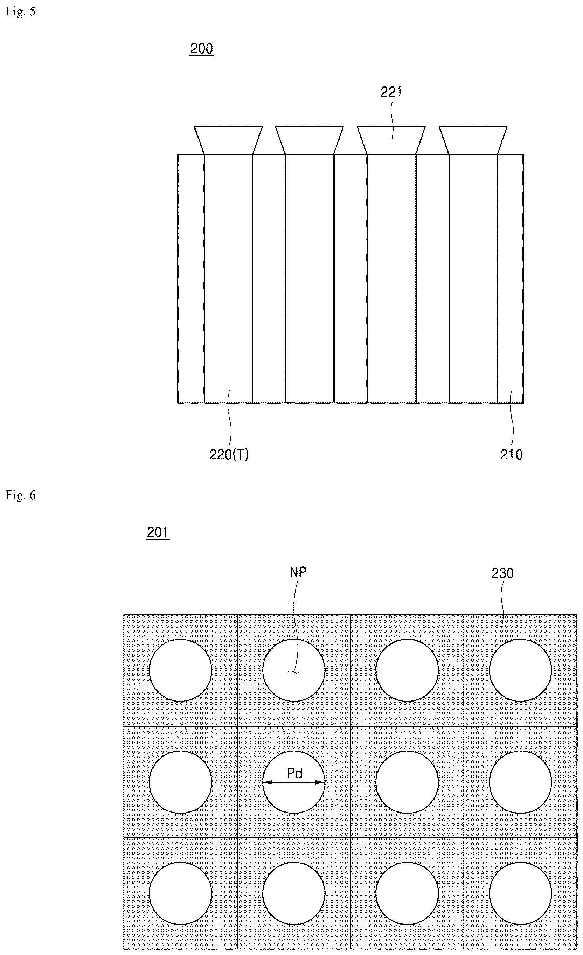

FIG. 5 is a cross-sectional view illustrating another embodiment of the nanochannels shown in FIG. 3.

Referring to FIG. 5, the nanochannel 220 according to another embodiment of the present disclosure may further include a graphene funnel 221 extending from the end portion of the carbon nanotube T, which penetrates the head body 210, toward the reservoir S.

For example, by providing a graphene funnel 221 formed by modifying the end portion of the carbon nanotube T into a funnel shape, the nanofluid NF supplied to individual nanochannels 220 configured as the carbon nanotubes T may be guided to flow from the inner surface 211 toward the outer surface 212 of the shower head 200.

The intrinsic strain of the graphene funnel 221 may have effect on the bandgap and exciton properties of the nanofluid NF entering the graphene funnel 221, thereby guiding the nanofluid NF to flow in a predetermined direction.

FIG. 6 is a perspective view illustrating a shower head according to another embodiment of the present disclosure.

Referring to FIG. 6, the shower head 201 according to another embodiment of the present disclosure may include a nanoporous membrane 230 including a plurality of nanopores NP and coupled to the supply member 100 such that the nanoporous membrane 230 is electrically insulated from the supply member 100 and isolates the reservoir S from the outside. In this case, the plurality of nanopores NP may serve as the nanochannels 220 for discharging the nanofluid NF.

The nanoporous membrane 230 may include a membrane structure in which nanoscaled pores NP are provided and may have a large surface area and a high pore volume. In particular, the nanoporous membrane 230 may have a large surface area per unit mass, providing efficient characteristics for fluid storage and transport.

In an embodiment, the nanoporous membrane 230 may have various compositions depending on the characteristics of the fine process. For example, the nanoporous membrane 230 may include any one of a graphene membrane, a graphene sheet, silica, alumina, titania, a metal-organic framework (MOF), a covalent organic framework (COF), and a combination thereof.

In this case, the plurality of nanopores NP may be uniformly arranged across the entire surface of the nanoporous membrane 230. Accordingly, the process fluid PF may be uniformly supplied to the shower head 200 from the reservoir S, and the nanofluid NF may be uniformly discharged from the shower head 200.

For example, the nanopores NP may have a pore diameter Pd in the range of approximately 0.5 nm to 20 nm. In this case, by appropriately adjusting the spacing between adjacent nanopores NP, the distance between nanofluids NF discharged from neighboring positions may be controlled. For example, the spacing between adjacent nanopores NP may be configured in the range of approximately 30% to 50% of the pore diameter Pd.

In this embodiment, although the plurality of nanochannels 220 are disclosed as being uniformly arranged on the surface of the shower head 200, this is merely illustrative, and the plurality of nanochannels may be arranged non-uniformly to have a specific shape.

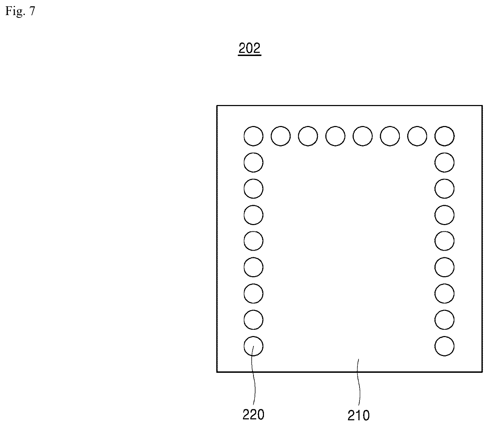

FIG. 7 is a plan view illustrating a shower head according to still another embodiment of the present disclosure.

Referring to FIG. 7, the shower head 202 according to still another embodiment of the present disclosure may include a plurality of nanochannels 220 penetrating the head body 210 and arranged in a predetermined pattern. That is, the plurality of nanochannels 220 may be arranged in the shower head 200 in a predetermined form corresponding to the pattern shape.

For example, the plurality of nanochannels 220 may be arranged such that a cross-sectional shape cut along the front surface of the head body 210 has a "C"-shaped pattern. Accordingly, the process fluid PF contained in the reservoir S may be supplied to the shower head 200 along the pattern shape, and the nanofluid NF may be discharged along the same pattern shape.

When the nanofluid NF needs to be discharged along the pattern shape corresponding to the characteristics of the fine process, the shower head 200, in which the nanochannels 220 are arranged along the pattern shape, may be coupled to the supply member 100, and then, the nanofluid NF may be supplied to the shower head 200.

Accordingly, a plurality of shower heads 200, each having nanochannels 220 optimally arranged according to the corresponding process, may be provided, and a specific shower head 200 corresponding to the process characteristics may be selected and used accordingly.

In an embodiment, the nanofluid driving unit 300 may apply a driving force to drive the nanofluid NF, such that the process fluid PF introduced into the nanochannels 220 may flow along the nanochannels 220 and be discharged as the nanofluid NF.

For example, the nanofluid driving unit 300 may include a power unit 310 and a flow control unit 320. The power unit 310 may generate a driving force for the nanofluid NF to pass through the nanochannels 220 by electroosmosis, and the flow control unit 320 may control the power unit 310 to regulate the flow velocity and flow rate of the nanofluid NF passing through the nanochannels 220.

The power unit 310 may include a first power supply 311 configured to apply a first electric field to cause the nanofluid NF to form an electric double layer within the nanochannels 220, and a second power supply 312 configured to apply a second electric field to cause the electric double layer to flow along the nanochannels 220, thereby discharging the nanofluid NF from the shower head 200.

For example, the first power supply 311 and the second power supply 312 may include a direct current (DC) power source. However, it will be apparent to those skilled in the art that, as long as the electric double layer is formed inside the nanochannels 220 and the electric double layer flows along the nanochannels 220, an alternating current (AC) power source may also be used as the power unit 310, as well as the direct current (DC) power source.

For example, the first power supply 311 may apply a current to the shower head 200 to provide the electric double layer at the interface between the head body 210 and the nanochannels 220, and the second power supply 312 may apply a current to the upper and lower portions of the shower head 200 to generate a second electric field directed linearly along the flow direction of the nanofluid NF.

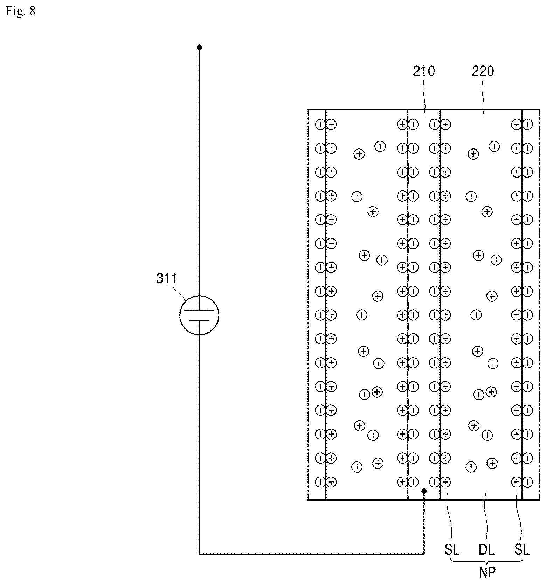

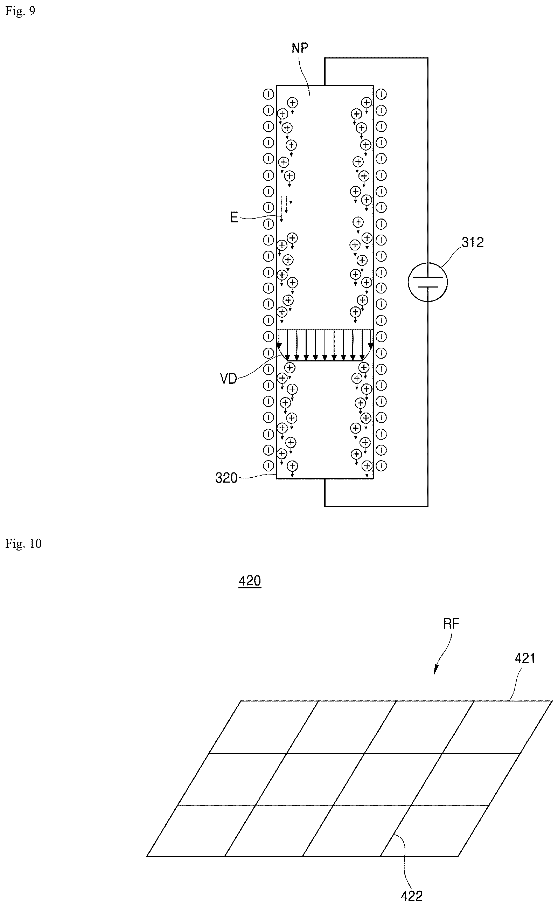

FIG. 8 is a view illustrating an electric double layer formed in a nanochannel according to an embodiment of the present disclosure, and FIG. 9 is a view illustrating the state in which the nanofluid flows as an electric field is applied to the electric double layer shown in FIG. 8.

Referring to FIGS. 8 and 9, in response to a start signal of the fine process, the flow control unit 320 may drive the first power supply 311 to apply a first electric field to the shower head 200. Thus, the process fluid PF introduced into the nanochannels 220, having a nanoscale size, may be formed as the nanofluid NF with an electric double layer.

When the first electric field is formed inside the nanochannels 220, the ions of the nanofluid NF in the nanochannels 220 may form a stern layer SL in the stern region adjacent to the inner surface of the nanochannels 220, where the ions contact the inner surface. The remaining region, excluding the stern region, may be surrounded by the stern layer SL and form a diffusion layer DL in which charges having a polarity opposite to that of the stern layer SL are relatively densely distributed.

Accordingly, the nanofluid NF may be formed into the electric double layer in the nanochannels 220, including the stern layer SL and the diffusion layer DL, under the influence of the first electric field.

In particular, in case of a polar solution such as an aqueous solution, the nanofluid NF may be formed as the electric double layer in the nanochannels 220 due to ion adsorption and redistribution, even in the absence of the first electric field. Accordingly, the first power supply 311 that generates the first electric field in the shower head 200 may be selectively applied depending on the process fluid PF and the characteristics of the fine process.

When the first electric field is applied to the shower head 200, the polarity of the ions distributed on the inner surface of the nanochannels 220, through which the nanofluid NF flows, and on the outer surface of the nanochannels 220 in contact with the head body 210, may be selectively controlled. Accordingly, the charge characteristics of the nanofluid NF discharged from the shower head 200 may be controlled.

Once the charge characteristics of the nanofluid NF, which is configured as the electric double layer by the first electric field, are established, a second electric field E may be applied to the nanochannels 220 to cause the electric double layer to flow along the flow direction. Accordingly, the nanofluid NF may be discharged from the shower head 200 by the second electric field E.

In particular, to achieve linear flow of the electric double layer along the flow direction, electric power may be applied such that the second electric field E is linearly aligned with the flow direction. For example, electric power may be applied to flat electrodes on the upper and lower portions of the nanochannels 220 along the flow direction, thereby generating a linear second electric field E along the nanochannels 220.

Accordingly, the nanofluid NF may be formed into the electric double layer by the first electric field and flow linearly along the nanochannels 220 under the influence of the second electric field E to be discharged from the outer surface 212 of the shower head 200.

The first electric field may include a circular electric field to form the electric double layer in the nanochannels 220, while the second electric field E is a linear electric field to transport the electric double layer. These electric fields may be generated independently, applying electric forces in different directions.

In this case, since the stern layer SL is in contact with the inner surface of the nanochannels 220 due to the first electric field, the flow of the nanofluid NF under the second electric field E primarily occurs in the diffusion layer DL, which is spaced away from the peripheral portion of the nanochannels 220.

Accordingly, the flow velocity VD of the stern layer SL varies so as to increase with distance from the inner surface of the nanochannels 220, whereas the flow velocity VD of the diffusion layer DL surrounded by the stern layer SL may be maintained constant in accordance with the intensity of the second electric field E.

Accordingly, the average flow rate of the nanofluid NF flowing through the nanochannels 220 may be determined by the average flow velocity VD of the electric double layer, which may be controlled by the intensity of the second electric field E.

That is, by controlling the intensity of the first electric field applied by the first power supply 311 and the second electric field E applied by the second power supply 312 through the flow control unit 320, the flow velocity and flow rate of the nanofluid NF along the nanochannels 220 may be regulated.

In particular, when the nanochannels 220 are configured as carbon nanotubes T having suppressed surface slip characteristics, the nanofluid NF may exhibit flow characteristics similar to macroscopic flow, with slip being negligible even at the nanoscale.

Accordingly, the flow control unit 320 may enhance the control precision of the flow velocity of the nanofluid NF passing through the nanochannels 220.

Referring again to FIGS. 1 and 2, an auxiliary head 400 may be selectively disposed on at least one of the inner surface 211 and the outer surface 212 of the shower head 200 to assist the properties or functions of the shower head 200.

For example, the auxiliary head 400 may include an injection head 410 having a plate-shaped structure covering the entire shower head 200 and perforated in a predetermined pattern, thereby providing an exposure pattern EP that selectively exposes the shower head 200.

The injection head 410 may have a predetermined thickness and be configured in the same shape as the shower head 200, while the injection head 410 may be arranged on the shower head 200 to cover the entire inner surface 211 or outer surface 212 of the shower head 200. Thus, the shower head 200 may be fully covered by the injection head 410.

An exposure pattern EP may be provided with the injection head 410 in a predetermined pattern shape. The exposure pattern EP may be an opening penetrating the injection head 410 and may extend along the pattern shape on the injection head 410.

Accordingly, the process fluid PF contained in the reservoir S may be supplied to the shower head 200 through the exposure pattern EP, thereby flowing only through the nanochannels 220 that communicate with the exposure pattern EP, while the nanochannels 220 covered by the injection head 410 are prevented from being supplied with the nanofluid NF.

That is, the nanofluid NF discharged from the shower head 200 may be guided along the shape of the exposure pattern EP. In other words, the nanofluid NF may be precisely discharged to processing positions of the processing object according to the pattern shape of the exposure pattern EP.

Since the nanofluid NF is discharged at the nanoscale, the processing position of the processing object may be determined with nanoscale precision, thereby forming a nanopattern or nanostructure with nanoscale accuracy.

For example, when the target onto which the nanofluid NF is discharged is a thin film formed on a substrate, and when the nanofluid NF is an etching solution, the thin film may be removed by etching along the shape of the exposure pattern EP.

In this case, the thin film may be etched at the nanoscale by the nanofluid etchant, and the residual thin film after etching may form a circuit pattern with nanoscale line widths.

As described above, although the circuit patterns with nanoscale line widths may be formed by the nanochannels 220 of the shower head 200 in a specific pattern, nanoscale nanostructures or nanopatterns may be easily formed by attaching an additional injection head 410 having the exposure pattern EP to the shower head 200, as disclosed in this embodiment.

FIG. 10 is a plan view illustrating the auxiliary head according to another embodiment of the present disclosure.

Referring to FIG. 10, the auxiliary head 400 according to another embodiment of the present invention may include a reinforcing head 420 covering at least a portion of the shower head 200 and configured to suppress deformation of the shower head 200 caused by pressure difference between the inner surface 211 and the outer surface 212.

For example, the reinforcing head 420 may be configured as a single reinforcing frame RF in which a plurality of transverse rods 421, arranged at regular intervals along the transverse direction, and a plurality of longitudinal rods 422, arranged at regular intervals along the longitudinal direction perpendicular to the transverse direction, are connected to intersect with each other.

In particular, in this embodiment, the reinforcing head 420 may be configured with the same exterior shape as the shower head 200, thereby uniformly supporting the shower head 200. Accordingly, even though deformation stress is generated within the shower head 200 due to the pressure difference between the inner surface 211 and the outer surface 212, the reinforcing frame RF may absorb the deformation stress, thereby preventing deformation of the shower head 200.

Thus, deviation of the dispensing position of the nanofluid NF from the designed position due to deformation of the shower head 200 may be suppressed, thereby reducing process defects in the fine process.

According to the nanofluid dispenser 500 as described above, the flow path of the shower head 200 may include nanochannels 220 having nanoscale dimensions, and the fluid inside the nanochannels 220 may flow by electroosmosis, thereby discharging the process fluid PF contained in the reservoir S through the shower head 200 as the nanofluid NF with nanoscale precision.

The processing object, onto which the nanofluid NF is dispensed, may be formed into a nanostructure with nanoscale dimensions depending on the properties of the nanofluid. When an etching solution is used as the nanofluid NF, the processing object may be formed into a circuit pattern with nanoscale line widths, and when a cleaning solution is used as the nanofluid NF, the etched areas may be cleaned with nanoscale precision. In addition, when a film-forming fluid is used as the nanofluid NF, a nanostructure with nanoscale line widths may be directly deposited or formed on the processing object.

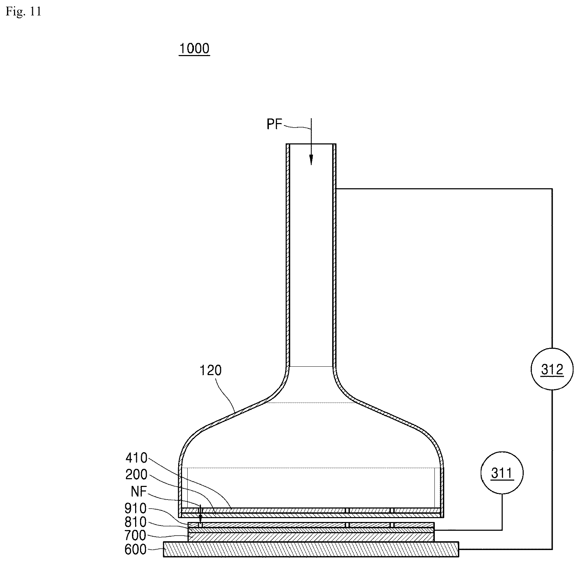

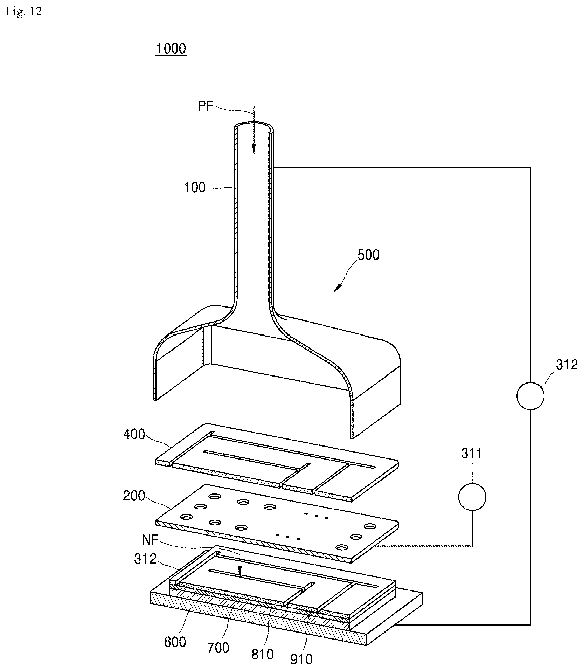

FIG. 11 is a schematic diagram illustrating a semiconductor device manufacturing apparatus equipped with the nanofluid dispenser shown in FIG. 1, and FIG. 12 is an exploded perspective view illustrating the semiconductor device manufacturing apparatus shown in FIG. 11.

In this embodiment, the nanofluid dispenser 500 may have substantially the same configuration as the nanofluid dispenser 500 described with reference to FIGS. 1 to 10. Therefore, in FIGS. 11 and 12, the same reference numerals are used for the same components as in FIGS. 1 to 10, and no further detailed description will be provided for such components.

Referring to FIGS. 11 and 12, an apparatus 1000 for manufacturing a semiconductor device (hereinafter, referred to as semiconductor device manufacturing apparatus) according to an embodiment of the present disclosure may include a conductive stage 600 arranged in a sealed process chamber (not shown), a semiconductor substrate 700 placed on the stage 600 with a processing object PO disposed on an upper surface thereof, and a nanofluid dispenser 500 fixed to the process chamber over the semiconductor substrate 700.

For example, the semiconductor device manufacturing apparatus 1000 may perform a predetermined fine process in a low-pressure chamber, such as a vacuum chamber. The stage 600 may be provided at the bottom of the low-pressure chamber, and the nanofluid dispenser 500 may be arranged on the ceiling of the low-pressure chamber opposite to the stage 600, so that the nanofluid NF may be supplied into the chamber from the ceiling side.

In an embodiment, the stage 600 may be configured to function as a conductive susceptor capable of applying various types of electric forces to the semiconductor substrate 700 thereon. For example, the stage 600 may be formed as an electrostatic chuck configured to hold the semiconductor substrate 700 and/or to apply an electric field to the held semiconductor substrate 700.

In an embodiment, the semiconductor substrate 700 may include various substrates for manufacturing semiconductor devices. For example, the semiconductor substrate 700 may include substrates such as a semiconductor substrate on which a gate channel of a semiconductor device is formed, or an interposer substrate supporting semiconductor devices and including interconnection wirings. For example, the semiconductor substrate 700 may include silicon, germanium, and alloys thereof.

The processing object PO may include various film structures or patterned structures formed on the semiconductor substrate 700 through previous processes.

For example, the processing object PO may include a film structure such as a thin film formed on the semiconductor substrate 70 by a film-forming process and a stacked film in which an etching mask layer is staked on the thin film. The semiconductor substrate 700, on which the film structure is formed, may be loaded onto the stage 600, and a nanofluid etchant may be discharged to perform a nano-etching process on the film structure.

Alternatively, the processing object PO may include patterned structures formed by the nano-etching process described above. The semiconductor substrate 700, on which the pattern structure is formed by the nano-etching process, may be loaded onto the stage 600, and a nanofluid cleanser may be discharged to perform a nano-cleaning process on the pattern structure.

In addition, the processing object PO may include a nano template having a plurality of nanopores. The semiconductor substrate 700, on which the nano template is formed, may be loaded onto the stage 600, and a deposition nanofluid may be discharged into each nanopore, thereby forming a nanostructure grown within each nanopore.

However, this is merely illustrative, and the processing object PO may include various film structures or patterned structures as long as nanoscale processing is required in various unit processes for manufacturing semiconductor devices.

In an embodiment, the nanofluid dispenser 500 may be positioned over the processing object PO and may supply the process fluid PF for treating the processing object PO as the nanofluid NF with nanoscale precision.

In this case, the nanofluid dispenser 500 may include a supply member 100 supplying a process fluid PF and having a reservoir S in which the process fluid PF is temporarily contained, a shower head 200 coupled to one end of the supply member 100 to define the reservoir S and having a plurality of nanochannels 220 through which the process fluid PF flows as a nanofluid NF such that the shower head 200 is electrically insulated from the supply member 100 and the nanofluid NF is discharged, a nanofluid driving unit 300 that applies driving force to cause the nanofluid NF to flow through the nanochannels 220, and an auxiliary head 400 disposed on the shower head 200 to reinforce the strength of the shower head 200 or to provide an exposure pattern EP.

The shower head 200 may include a head body 210 made of a hydrophobic insulating material and coupled to the supply member 100 to separate the reservoir S from the outside, and each of the plurality of nanochannels 220, which is, for example, formed of a carbon nanotube T, may pass through the head body 210 to allow the reservoir S to communicate with the outside.

In particular, each nanochannel 220 may further include a graphene funnel 221 at the end of the carbon nanotube T positioned toward the reservoir S, so that the process fluid PF may be guided into the corresponding nanochannel 220. Alternatively, the shower head 200 may include a nanoporous membrane 230 having a plurality of nanopores NP provided as the plurality of nanochannels 220.

The auxiliary head 400 may be disposed on at least one of the inner surface 211 of the shower head 200, which defines the reservoir S, and the outer surface 212 of the shower head 200, spaced from the inner surface 211 by the thickness of the shower head 200.

For example, the auxiliary head 400 may include an injection head 410 having a plate shape covering the entire shower head 200 and perforated in a predetermined pattern, thereby providing an exposure pattern EP that selectively exposes the shower head 200 and thereby defines a discharge area of the nanofluid NF.

The injection head 410 may be arranged to cover the entire front surface of the shower head 200, so that nanochannels 220 not communicating with the exposure pattern EP are blocked by the injection head 410. Thus, the nanofluid NF may be discharged only through the nanochannels 220 that communicate with the exposure pattern EP. Accordingly, the nanofluid NF may be discharged according to the pattern shape of the exposure pattern EP.

Alternatively, the auxiliary head 400 may include a reinforcing head 420 arranged to cover at least a portion of the shower head 200. The reinforcing head 420 may reduce or prevent the deformation of the shower head 200 caused by pressure difference between the inner surface 211 and the outer surface 212.

The nanofluid driving unit 300 may include a power unit 310 that generates a driving force for the nanofluid NF to flow through the nanochannels 220 by electroosmosis, and a flow control unit 320 that controls the power unit 310 to regulate the flow velocity of the nanofluid NF passing through the nanochannels 220.

In this case, the power unit 310 may include a first power supply 311 that applies a first electric field to cause the nanofluid NF to form an electric double layer within the nanochannels 220, and a second power supply 312 that applies a second electric field E to cause the electric double layer to flow along the nanochannels 220 by electroosmosis.

In particular, the first power supply 311 may be connected to the shower head 200 to generate the first electric field having a circular distribution around the nanochannels 220, and the second power supply 312 may be connected to the supply member 100 and the stage 600 to generate the second electric field E extending linearly along the nanochannels 220.

The processing object PO may be provided in various forms depending on the unit process for manufacturing semiconductor devices.

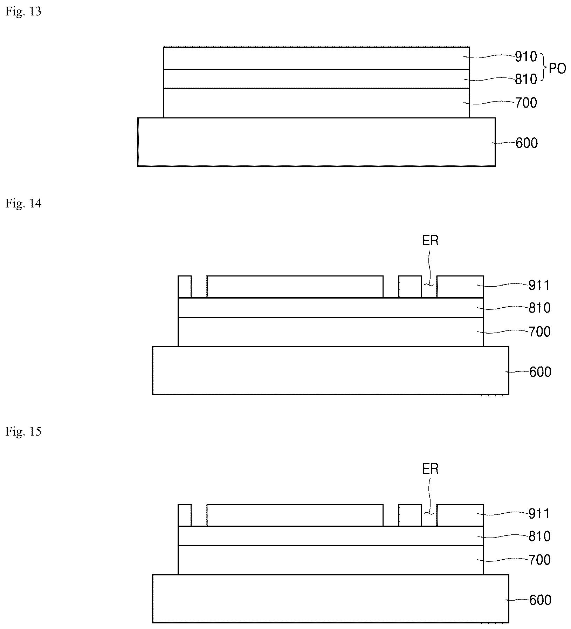

FIGS. 13 to 15 are cross-sectional views illustrating steps of performing the nano-etching process on the processing object disposed on a semiconductor substrate, according to an embodiment of the present disclosure.

FIGS. 13 to 15 are cross-sectional views illustrating processing steps of performing the nano-etching process for forming a nano-etching pattern, using the semiconductor device manufacturing apparatus 1000 shown in FIGS. 11 and 12.

Referring to FIGS. 13 to 15, the processing object PO may include a thin film 810 disposed on the semiconductor substrate 700 and an etching mask layer 910 for etching the thin film 810.

The thin film 810 may include various conductive or insulating films formed on the semiconductor substrate 700 through film-forming processes such as coating or deposition. For example, the thin film 810 may be configured as a gate conductive film for forming the gate electrode of a semiconductor device, or as an insulating film for separating multilayer metal interconnections.

In this disclosure, the thin film 810 is illustrated as disposed on the semiconductor substrate 700; however, this is merely illustrative, and it will be apparent to those skilled in the art that various patterned structures may additionally be provided between the semiconductor substrate 700 and the thin film 810 as unit processes for manufacturing semiconductor devices are performed.

After forming the thin film 810, the etching mask layer 910 covering the thin film 810 may be formed through a film-forming process. The mask layer 910 may have an appropriate composition depending on the properties of the thin film 810 or the characteristics of the etching solution and may be formed by a film-forming process such as deposition or coating according to the properties of the composition.

In this case, an etching fluid for etching the etching mask layer 910 may be supplied as the process fluid PF through the supply member 100 and may be discharged through the nanochannels 220 to the etching mask layer 910 as a nanofluid NF.

In this case, the nanofluid NF may be discharged along the pattern shape corresponding to the arrangement form of the nanochannels 220 in the shower head 200 or along the exposure pattern EP in the injection head 410.

That is, the etching nanofluid NF may be discharged onto the mask layer 910 according to the pattern shape, thereby partially etching the mask layer 910. Accordingly, the mask layer 910 may be patterned to a mask pattern 911 in which etching recesses ER are formed in accordance with the pattern shape.

In this case, since the nanofluid NF is discharged with nanoscale precision, the etching recess ER may have a width at the nanoscale. That is, the mask pattern 911 may be formed as a nanopattern with a nanoscale line width.

Since the mask pattern 911 is a transferred pattern corresponding to the exposure pattern EP of the injection head 410 or the arrangement form of the nanochannel 220 of the shower head 200, various nano mask pattern having different shapes may be formed by adjusting the exposure pattern EP or the arrangement form of the nanochannels 220.

Thereafter, an etching process using the mask pattern 911 as an etching mask may be performed to partially etch the exposed thin film 810 through the etching recesses ER. Accordingly, a thin film pattern 811 corresponding to the exposure pattern EP may be formed on the semiconductor substrate 700.

Since the etching recess ER has a width at the nanoscale, the thin film pattern 811, which is formed by etching using the mask pattern 911 as an etching mask, may also be formed as a circuit pattern with a nanoscale width.

In particular, when a photoresist layer is used as the etching mask layer 910, a photoresist pattern having a smaller line width than resolution limit of a conventional exposure process may be formed by an etching process using the etching mask layer 910.

For example, when the nanochannel 220 has a width of several nanometers, the width of the etching nanofluid NF may become smaller than the wavelength of ultraviolet light. Thus, the photoresist layer may be etched to form the photoresist pattern having a line width smaller than that obtainable by EUV exposure.

Accordingly, the etching nanofluid NF for etching the photoresist layer may be configured to have a width smaller than the resolution of the EUV equipment, thereby overcoming the resolution limit of the conventional exposure process and facilitating the formation of a circuit pattern having a line width of several nanometers.

In addition, after forming the mask pattern 911 shown in FIG. 14 or after forming the thin film pattern 811 shown in FIG. 15, the cleaning nanofluid NF may be discharged to clean the mask pattern 911 or the thin film pattern 811.

Since the mask pattern 911 or the thin film pattern 811 is formed into a nanopattern with nanoscale precision, the cleaning nanofluid NF having a width corresponding to the spacing of the nanopattern may be discharged to perform a nano-cleaning process on the mask pattern 911 or the thin film pattern 811.

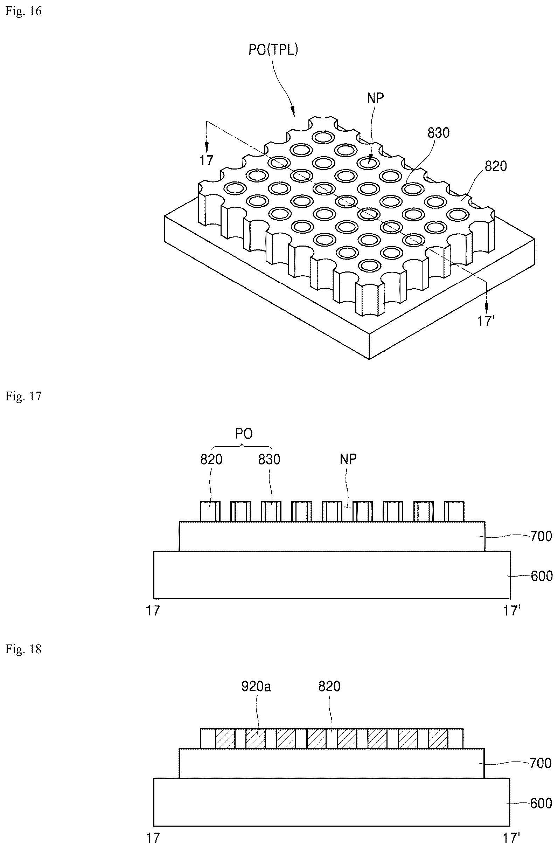

FIGS. 16 to 19 are cross-sectional views illustrating steps of performing a nano-deposition process on the processing object disposed on a semiconductor substrate, according to an embodiment of the present disclosure.

FIGS. 16 to 19 are cross-sectional views illustrating processing steps of forming a nano-deposition pattern by performing the nano-deposition process, using the semiconductor device manufacturing apparatus 1000 illustrated in FIGS. 11 and 12.

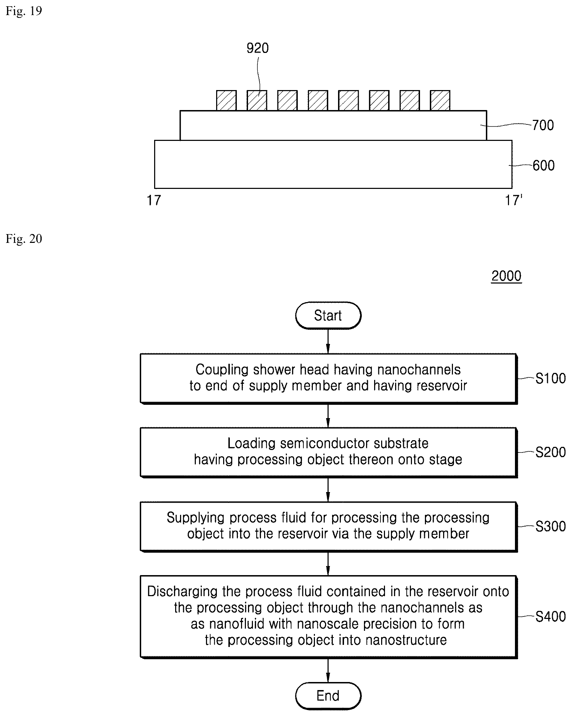

Referring to FIGS. 16 to 19E, a nano template TPL having a plurality of nanopores NP may be disposed on the semiconductor substrate 700.

The nano template TPL may include a body layer 820 having a predetermined thickness, which covers the semiconductor substrate 700 and has a plurality of nanopores NP arranged in a matrix form to partially expose the semiconductor substrate 700.

For example, the body layer 820 may include a metal layer composed of a low-resistance metal such as aluminum (Al), titanium (Ti), tantalum (Ta), and tungsten (W), and a plurality of nanopores NP may be formed through the metal layer by a cathodic oxidation process to partially expose the semiconductor substrate 700.

The nanopore NP may be formed as a penetrating hole passing through the body layer 820 with nanoscale precision by adjusting process parameters of the cathodic oxidation process applied to the body layer 820. For example, the nanopore NP may be formed as a circular hole having a diameter of approximately 30 nm to 40 nm.

Optionally, a catalyst layer 830 may be formed on the inner surface of the body layer 820 defining the nanopore NP via an atomic layer deposition process. The catalyst layer 830 may control the diameter of the nanopore NP to adjust its aspect ratio and may serve as a seed layer for carbon deposition within the nanopores NP.

For example, the catalyst layer 830 may include any one of aluminum (Al), iron (Fe), cobalt (Co), and nickel (Ni). For example, when the body layer 820 is composed of aluminum (Al), the catalyst layer 830 may be formed of aluminum oxide. In this embodiment, the catalyst layer 830 may be formed of a film having a thickness of approximately 1 nm to 3 nm.

However, the catalyst layer 830 may be selectively provided, and no catalyst layer may be provided depending on the characteristics of the deposition process for the nanopores NP.

The semiconductor substrate 700 on which the nano template TPL is disposed as described above may be arranged on the stage 600 of the deposition chamber, and the nanofluid dispenser, which is positioned over the nano template TPL, may discharge the nanofluid NF into the exposure pattern EP corresponding to the plurality of nanopores NP of the nano template TPL.

That is, the shower head 200 may be configured such that the plurality of nanopores NP correspond individually to the nanochannels 220, and the nanofluid NF may be supplied to each nanopore NP to form a nanostructure within the nanopores NP.

For example, the nanofluid NF may include a carbon deposition fluid configured to deposit carbon atoms. The carbon deposition fluid may include a fluid containing carbon atoms, which may decompose at high temperatures to supply carbon. In this embodiment, the carbon deposition fluid may include carbon-based gases, such as methane (CH4), acetylene (C2H2), and ethylene (C2H4).

Carbon in the carbon deposition fluid may be individually supplied to the nanopores NP at the nanoscale through the nanochannels 220, so that the nanopores NP may be filled with carbon via the deposition process. In this case, the diameter of the nanochannel 220 may be configured to be smaller than that of the nanopore NP, so that the nanofluid NF may be reliably discharged into the nanopore NP.

Carbon may be grown into carbon structures filling the nanopores NP through individual growth within each nanopore NP. In this case, the catalyst layer 830 may function as a seed for carbon deposition, thereby promoting the growth rate of the carbon structure.

In particular, since nanopores NP are provided at the nanoscale, the carbon structures filling the nanopores NP may be formed as nanostructures with nanoscale precision. That is, the carbon nanostructures may be formed as a nano-deposition pattern 920a in which the carbon nanostructures are in contact with the semiconductor substrate 700 within each nanopore NP and adjacent to one another in the body layer 820.

In this case, the carbon deposition fluid with nanoscale dimensions is individually discharged into the nanopores NP and grows separately within each nanopore NP to form the nano-deposition pattern 920a, thereby enhancing the layer characteristics of the deposition pattern compared to the conventional vapor deposition process performed on the entire surface of the body layer 820.

In this embodiment, the nanofluid NF may be formed with a diameter of approximately 0.3 nm to 40 nm, thereby forming the nano-deposition pattern 920a with nanoscale precision and without filling defects, regardless of the aspect ratio of the nanopores NP.

For example, the carbon structure may be formed as carbon nanochannels that fills the nanopores NP. Thus, the nano-deposition pattern 920a may be formed as a nanochannel pattern in which a plurality of carbon nanochannels are embedded in the body layer 820 and arranged in a matrix form.

After forming the nano-deposition pattern 920a, the body layer 820 may be selectively removed from the semiconductor substrate 700. Accordingly, the plurality of carbon structures constituting the nano-deposition pattern 920a may form a carbon structure array 920 arranged on the semiconductor substrate 700 in a matrix form.

In this embodiment, the semiconductor substrate 700 may include a plurality of dynamic random access memory (DRAM) devices, and the plurality of carbon nanochannels constituting the carbon structure array 920 may be provided as capacitors that are connected one-to-one with the DRAM devices.

According to the semiconductor device manufacturing apparatus 1000 described above, the nanofluid dispenser 500 may be arranged on the ceiling of the fine process chamber to discharge the nanofluid NF onto the processing object PO disposed on the stage 600, thereby performing a fine process for manufacturing semiconductor devices. Accordingly, a nanopattern having a line width smaller than the resolution limit of a lithography process may be easily formed.

For example, an etching nanofluid NF may be discharged to form a circuit pattern having a nanoscale line width with ease, and a deposition nanofluid NF may be individually discharged into a plurality of nanopores NP to form a nano-deposition pattern with ease.

FIG. 20 is a flowchart illustrating a method of manufacturing a semiconductor device using the semiconductor device manufacturing apparatus disclosed in FIGS. 11 and 12.

Hereinafter, the nanofluid NF may be discharged through the nanofluid dispenser 500 described with reference to FIGS. 1 to 10. Accordingly, in FIG. 20, the same reference numerals are used for the same components as in FIGS. 1 to 10, and no further detailed description will be provided for such components.

Referring to FIG. 20, the shower head 200 having nanochannels 220 may be coupled to an end of the supply member 100, which is positioned at an upper portion of the process chamber for performing a fine process and is provided with the reservoir S, so that the reservoir S is defined to communicate with the outside through the nanochannels 220 (step S100).

The supply member 100 may include the transfer tube 110 for transporting the process fluid PF and the open-type reservoir cover 120 that is connected to the transfer tube 110 so as to define the reservoir S and has a diameter greater than that of the transfer tube 110, and the shower head 200 may be coupled to the reservoir cover 120 so as to define the reservoir S together with the reservoir cover 120.

Since the shower head 200 is provided with a plurality of nanochannels 220, the reservoir S may communicate with the outside of the reservoir S through the nanochannels 220. After coupling the shower head 200 to the reservoir cover 120, the upper and lower portions of the process chamber may be assembled such that the reservoir cover 120 and the shower head 200 are positioned inside the process chamber.

Accordingly, the internal space of the process chamber may be sealed from the outside, such that the stage 600 on which the semiconductor substrate 700 is placed is provided at the bottom, and the supply member 100 defining the reservoir S together with the shower head 200 is installed at the ceiling opposite to the stage within the process chamber.

In this case, the nanochannels 220 may be uniformly distributed across the front surface of the shower head 200, so that the nanofluid NF flowing through the nanochannels 220 may be uniformly discharged onto the entire surface of the processing object PO disposed on the semiconductor substrate 700.

In another embodiment, when the nanofluid NF is required to be discharged in a specific pattern shape, the injection head 410 having the exposure pattern EP distributed along the pattern shape may be coupled to the shower head 200 before the supply member 100 and the shower head 200 are assembled.

When the injection head 410 is coupled to the shower head 200, the nanofluid NF may be discharged along the exposure pattern EP, so that the processing object PO may be treated in accordance with the shape of the exposure pattern EP.

when completing the coupling between the supply member 100 and the shower head 200, the semiconductor substrate 700, on which the processing object PO is disposed, may be loaded onto the stage 600 that is opposite to the shower head 200 in the process chamber (step S200).

The processing object PO may include a thin film 810 or a pattern structure formed by a unit process for manufacturing a semiconductor device performed prior to the fine process.

The semiconductor substrate 700 may be unloaded from the process chamber of the previous process and transferred to the process chamber for the current fine process by a transfer member such as a robot arm, and then loaded onto the stage 600.

The semiconductor substrate 700 loaded onto the stage 600 may be mechanically or electrically secured to the stage 600, and the process chamber is sealed from the outside. Subsequently, the internal temperature and pressure of the process chamber for performing the fine process may be set.

After the shower head 200 is coupled to the supply member 100, the semiconductor substrate 700 having the processing object PO thereon is loaded, and the process chamber is sealed from the outside, the process fluid PF for processing the processing object PO may be supplied to the reservoir S through the supply member 100 (Step S300).

For example, the process fluid PF may be supplied from the fluid source (not shown) into the process chamber by driving a pressurizing unit 111, such as a pressurizing pump. The process fluid PF, transported along the transfer tube 110, may be contained in the reservoir S, be formed as the nanofluid NF by flowing through the nanochannels 220, and finally be discharged onto the processing object PO.

In this case, since the process fluid PF may be transported by the pressurizing unit 111 under a predetermined pressure, a reservoir pressure, which is the pressure applied to the process fluid PF contained in the reservoir S, may be higher than the process pressure, which is the internal pressure of the chamber around the processing object PO.

Accordingly, the pressure difference may arise between the inside of the process chamber and the reservoir space S, resulting in a pressure gradient toward the processing object PO within the reservoir S.

The pressure gradient may function as a driving force that causes the process fluid PF to flow from the reservoir S through the nanochannels 220 toward the processing object PO. In particular, when the interior of the process chamber is maintained at a vacuum pressure according to the characteristics of the fine process, the reservoir pressure itself may serve as the pressure gradient.

When the process fluid PF flows into a flow path with nanoscale precision, the entrance pressure barrier generally acts against the entering flow. The pressure gradient acts along the nanochannels 220 and may serve as part of the driving force that allows the process fluid PF contained in the reservoir S to overcome the entrance pressure barrier when entering the nanochannels 220.

Thereafter, the process fluid PF contained in the reservoir S may be discharged through the nanochannels 220 as the nanofluid NF with nanoscale precision, thereby forming the processing object PO into a nanostructure (step S400).

For example, the first power supply 311 may be connected to the shower head 200 to generate a first electric field, which is a circular electric field surrounding the nanochannels in a circular manner. The first electric field may form the nanofluid NF within the nanochannels 220 as an electric double layer.

That is, the charged particles of the nanofluid NF may be separated into cations and anions by the first electric field, and divided into a stern layer SL, in which one type of ion is brought into contact with the surface of the nanochannels 220 due to the electric force, and a diffusion layer DL, in which the other type of ions, having a polarity opposite to that of the stern layer SL, are relatively densely distributed and are surrounded by the stern layer SL.

Accordingly, the nanofluid NF may flow through the nanochannels 220 by electroosmosis.

When the second power supply is connected to both ends of the nanochannel 220, in which the nanofluid NF is formed into an electric double layer, to apply the second electric field, which is a linear electric field along the nanochannels 220, the diffusion layer DL having electrical polarity may flow along the nanochannels 220 under the second electric field E.

The electric force generated by the second electric field, together with the pressure gradient, may provide the driving force exceeding the entrance pressure barrier to the nanofluid NF, thereby enabling the diffusion layer DL to flow along the nanochannel 220.

As the diffusion layer DL moves, the stern layer SL is carried along with the diffusion layer DL, causing the nanofluid NF to flow through the nanochannel 220. Accordingly, the flow of the nanofluid NF from the reservoir S toward the processing object PO may be established.

In particular, the nanochannels 220 may be formed of carbon nanotubes T or a porous membrane having nanopores NP, thereby suppressing slip effects of fluid behavior at the nanoscale. Accordingly, the control characteristics of the nanofluid NF flowing through the nanochannel 220 may be enhanced.

The nanofluid NF discharged onto the processing object PO may perform the corresponding fine process on the processing object PO according to the characteristics of the nanofluid NF.

When the nanofluid NF is an etching fluid, the processing object PO, composed of the thin film 810, may be patterned into a nano-etching pattern with nanoscale line widths. When the nanofluid NF is a deposition fluid, a nano-deposition pattern having nanoscale thickness may be formed on the semiconductor substrate 700. In addition, when the nanofluid NF is a cleaning fluid, the nano-etching pattern or the nano-deposition pattern may be cleaned at the nanoscale.

In particular, when the nanofluid NF is discharged through uniformly distributed nanochannels 220, the nanofluid NF may be evenly discharged across the entire surface of the processing object PO.

In contrast, when discharged along the exposure pattern EP arranged on the injection head 410, the nanofluid NF may be discharged toward the processing object PO along the pattern shape of the exposure pattern EP, and may be unevenly discharged over certain areas of the processing object PO. In this case, the processing object PO may be processed according to the pattern shape of the exposure pattern EP and formed into a nanopattern corresponding to the pattern shape.

According to an embodiment of the present invention as described above, the nanofluid dispenser 500, the semiconductor device manufacturing apparatus 1000 including the same, and the method 2000 for manufacturing a semiconductor device using the same, the flow path of the shower head 200 may be configured as the nanochannels 220 with nanoscale precision, and the process fluid PF may flow through the nanochannels 220 by electroosmosis, so that the process fluid PF contained in the reservoir S is discharged through the shower head 200 as the nanofluid NF with nanoscale precision.

In particular, when the nanochannels 220 are formed of carbon nanotubes T, the flow velocity of the nanofluid NF flowing through the nanochannels 220 may be effectively controlled by the pressure gradient and the electric field applied along the nanochannels 220. Accordingly, the nanofluid NF supplied through the nanofluid dispenser 500 may be sufficiently controlled.

The nanofluid dispenser 500 may be arranged on the ceiling of the fine process chamber, while the processing object PO is disposed on the semiconductor substrate 700 secured to the stage 600 at the bottom of the chamber, so that the downwardly discharged nanofluid NF may treat the processing object PO to form a nano-etching pattern or a nano-deposition pattern with nanoscale dimensions.

Accordingly, a nanopattern having a line width smaller than the resolution limit of a lithography process may be easily formed.

While the present invention has been described with reference to the exemplary embodiments and drawings above, the invention is not limited to the embodiments and drawings disclosed herein. It will be apparent to those skilled in the art that various modifications may be made without departing from the spirit and scope of the present invention. In addition, even though the effects of the present invention resulting from its specific configurations were not explicitly described in the foregoing embodiments, it is understood that the effects reasonably predictable from such configurations are also to be recognized.

## Claims

1. A nanofluid dispenser comprising:
a supply member configured to transport a process fluid to a semiconductor fine process for manufacturing semiconductor devices with nanoscale dimensions and to provide a reservoir in which the process fluid is contained;
a shower head coupled to an end of the supply member to define the reservoir and including a plurality of nanochannels configured to allow the process fluid to flow from the reservoir with nanoscale dimensions, thereby discharging the process fluid as a nanofluid, the shower head including hydrophobic insulating material and being electrically insulated from the supply member; and
a nanofluid driving unit configured to apply a driving force to cause the nanofluid to flow along the nanochannels.

2. The nanofluid dispenser according to claim 1, wherein
the shower head includes a head body coupled to the end of the supply member and isolating the reservoir from the outside, and
the plurality of nanochannels is arranged to penetrate the head body to allow the reservoir to communicate with the outside of the reservoir.

3. The nanofluid dispenser according to claim 2, wherein
the head body includes a flat plate made of non-polar polymer.

4. The nanofluid dispenser according to claim 2, wherein
each of the plurality of nanochannels includes a carbon nanotube.

5. The nanofluid dispenser according to claim 4, wherein
the carbon nanotube includes at least one of a single-walled carbon nanotube and a multi-walled carbon nanotube.

6. The nanofluid dispenser according to claim 4, wherein
each of the plurality of nanochannels includes a graphene funnel at an end portion of the carbon nanotube positioned toward the reservoir, to guide the process fluid into the corresponding nanochannel.

7. The nanofluid dispenser according to claim 1, wherein
the shower head includes a nanoporous membrane having a plurality of nanopores, the nanoporous membrane being configured to be coupled to the end portion of the supply member and isolate the reservoir from the outside, and
the plurality of nanopores are provided as the nanochannels for discharging the nanofluid.

8. The nanofluid dispenser according to claim 7, wherein
the nanoporous membrane includes one of a graphene membrane and a graphene sheet.

9. The nanofluid dispenser according to claim 1, wherein the nanofluid driving unit includes:
a power unit configured to generate a driving force for the nanofluid NF to flow through the nanochannels by electroosmosis; and
a flow control unit configured to control the power unit to regulate the flow velocity of the nanofluid passing through the nanochannels,
wherein the power unit includes:
a first power supply configured to apply a first electric field to cause the nanofluid to form an electric double layer within the nanochannels; and
a second power supply configured to apply a second electric field to cause the electric double layer to flow along the nanochannels by electroosmosis.

10. A semiconductor device comprising:
a conductive stage;
a semiconductor substrate disposed on the conductive stage and having a processing object for manufacturing semiconductor devices thereon; and
a nanofluid dispenser arranged over the processing object and dispensing a process fluid for processing the processing object as a nanofluid with nanoscale precision,
wherein the nanofluid dispenser includes:
a supply member configured to transport the process fluid and to provide a reservoir in which the process fluid is contained;
a shower head of a hydrophobic insulating material coupled to an end of the supply member to define the reservoir and including a plurality of nanochannels configured to allow the process fluid to flow from the reservoir as the nanofluid, the shower head being electrically insulated from the supply member to discharge the nanofluid; and
a nanofluid driving unit configured to apply a driving force to cause the nanofluid to flow along the nanochannels.

11. The semiconductor device according to claim 10, wherein
the shower head includes a head body configured to be coupled to the end of the supply member so as to be electrically insulated from the supply member, and each of the plurality of nanochannels includes a carbon nanotube extending through the head body to allow the reservoir to communicate with the outside.

12. The semiconductor device according to claim 11, wherein
each of the plurality of nanochannels includes a graphene funnel provided at an end portion of the carbon nanotube positioned toward the reservoir to guide the process fluid into the corresponding nanochannel.

13. The semiconductor device according to claim 10, wherein
the shower head includes a nanoporous membrane having a plurality of nanopores as the plurality of nanochannels.

14. The semiconductor device according to claim 10, wherein the nanofluid driving unit includes:
a power unit configured to generate a driving force for the nanofluid to flow through the nanochannels by electroosmosis; and
a flow control unit configured to control the power unit to regulate the flow velocity of the nanofluid passing through the nanochannels,
wherein the power unit includes:
a first power supply configured to apply a first electric field to cause the nanofluid to form an electric double layer within the nanochannels; and
a second power supply configured to apply a second electric field to cause the electric double layer to flow along the nanochannels by electroosmosis.

15. The semiconductor device according to claim 14, wherein
the first power supply is connected to the shower head to generate the first electric field that is a circular electric field surrounding the nanochannels, and
the second power supply is connected to the supply member and the stage to generate the second electric field that is a linear electric field along the nanochannels.

## Amended claims

### Amended claims in accordance with Rule 137(2) EPC.

1. A nanofluid dispenser (500) comprising:
a supply member (100) configured to transport a process fluid (PF) to a semiconductor fine process for manufacturing semiconductor devices and to provide a reservoir (S) in which the process fluid (PF) is contained;
a shower head (200) coupled to an end of the supply member (100) to define the reservoir (S) and including a plurality of nanochannels (220) having a diameter of approximately 0.3nm to 40nm , preferably 0.5nm to 20nm, configured to allow the process fluid (PF) to flow from the reservoir (S), thereby discharging the process fluid (PF) as a nanofluid (NF), the shower head (200) including hydrophobic insulating material and being electrically insulated from the supply member (100); and
a nanofluid driving unit (300) configured to apply a driving force to cause the nanofluid (NF) to flow along the nanochannels (220),
wherein the nanofluid driving unit (300) includes:
a power unit (310) configured to generate a driving force for the nanofluid (NF) to flow through the nanochannels (220) by electroosmosis; and
a flow control unit (320) configured to control the power unit (310) to regulate the flow velocity of the nanofluid (NF) passing through the nanochannels (220),
wherein the power unit includes:
a first power supply (311) configured to apply a first electric field to cause the nanofluid (NF) to form an electric double layer within the nanochannels (220); and
a second power supply (312) configured to apply a second electric field to cause the electric double layer to flow along the nanochannels (220) by electroosmosis.

2. The nanofluid dispenser (500) according to claim 1, wherein
the shower head (200) includes a head body (210) coupled to the end of the supply member (100) and isolating the reservoir (S) from the outside, and
the plurality of nanochannels (220) is arranged to penetrate the head body (210) to allow the reservoir (S) to communicate with the outside of the reservoir (S).

3. The nanofluid dispenser (500) according to claim 2, wherein
the head body (210) includes a flat plate made of non-polar polymer.

4. The nanofluid dispenser (500) according to claim 2, wherein
each of the plurality of nanochannels (220) includes a carbon nanotube.

5. The nanofluid dispenser (500) according to claim 4, wherein
the carbon nanotube includes at least one of a single-walled carbon nanotube and a multi-walled carbon nanotube.

6. The nanofluid dispenser (500) according to claim 4, wherein
each of the plurality of nanochannels (220) includes a graphene funnel (221) at an end portion of the carbon nanotube positioned toward the reservoir (S), to guide the process fluid (PF) into the corresponding nanochannel (NF).

7. The nanofluid dispenser (500) according to claim 1, wherein
the shower head (200) includes a nanoporous membrane (230) having a plurality of nanopores, the nanoporous membrane (230) being configured to be coupled to the end portion of the supply member (100) and isolate the reservoir (S) from the outside, and
the plurality of nanopores (NP) are provided as the nanochannels (220) for discharging the nanofluid (NF).

8. The nanofluid dispenser (500) according to claim 7, wherein
the nanoporous membrane (230) includes one of a graphene membrane and a graphene sheet.

9. An apparatus (1000) for manufacturing a semiconductor device comprising:
a conductive stage (600);
a semiconductor substrate (700) disposed on the conductive stage (600) and having a processing object (PO) for manufacturing semiconductor devices thereon; and
a nanofluid dispenser (500) according to any of claims 1 to 8 arranged over the processing object (PO) and dispensing a process fluid (PF) for processing the processing object (PO) as a nanofluid (NF) with nanoscale precision.

10. The apparatus according to claim 9, wherein
the first power supply (311) is connected to the shower head (200) to generate the first electric field that is a circular electric field surrounding the nanochannels (220), and
the second power supply (312) is connected to the supply member (100) and the conductive stage (600) to generate the second electric field that is a linear electric field along the nanochannels (220).
